Europäisches Patentamt

(19) European Patent Office

Office européen des brevets

(11) Numéro de publication : **0 458 678 A1**

# (12) DEMANDE DE BREVET EUROPEEN

(21) Numéro de dépôt : **91401258.8**

(51) Int. Cl.⁵ : **G01R 31/26**

(22) Date de dépôt : **15.05.91**

(30) Priorité : **17.05.90 FR 9006172**

(43) Date de publication de la demande :
**27.11.91 Bulletin 91/48**

(84) Etats contractants désignés :
**DE FR GB IT NL**

(71) Demandeur : **COMMISSARIAT A L'ENERGIE ATOMIQUE**
**31-33, rue de la Fédération**
**F-75015 Paris (FR)**

(72) Inventeur : **Guiga, Angelo**
**162, Avenue Victor Hugo**
**F-38170 Seyssinet (FR)**
Inventeur : **Lucas, Christian**
**38, rue Saint Robert**
**F-38120 Saint Egreve (FR)**

(74) Mandataire : **Mongrédien, André et al**
**c/o BREVATOME 25, rue de Ponthieu**
**F-75008 Paris (FR)**

(54) **Dispositif automatique pour la mesure du niveau de bruit de composants électroniques.**

(57)    Dispositif automatique pour la mesure du niveau de bruit de composants électroniques.
    Ce dispositif comprend des moyens de sélection (20) auxquels sont connectés les composants et qui sont aptes à sélectionner l'un de ces composants, des moyens de mesure (28) aptes à déterminer le bruit du composant sélectionné, ces moyens de mesure comprenant des moyens (32, 34) de polarisation du composant sélectionné et de traitement des signaux fournis par le. composant sélectionné ainsi polarisé et comprenant également des moyens (36) d'analyse qui déterminent le bruit à partir des signaux fournis par les moyens de traitement, et des moyens (10) de commande des moyens (20) de sélection et des moyens (28) de mesure, ces moyens de commande (10) étant découplés électriquement des moyens de sélection (20) et des moyens de polarisation et de traitement (32, 34).
    Application au tri de composants électroniques après fabrication de ceux-ci.

EP 0 458 678 A1

FIG. 1

La présente invention a pour objet un dispositif automatique pour la mesure du bruit de composants électroniques en particulier dans le domaine des basses fréquences (0,01 Hz à 1 MHZ). Elle s'applique notamment à la détection de défauts pour le tri de composants, pour l'établissement de critères de qualité, pour favoriser l'étude statistique des problèmes de qualité et pour analyser et corréler avec des modèles les sources de bruit détectées.

On connaît plusieurs types de mesure qui permettent de détecter des défauts dans des composants électroniques en particulier microélectriques. Une mesure importante concerne la détermination du niveau de bruit engendré par les composants. Dans des applications de type analogique, en imagerie par exemple, les performances des composants utilisés sont en général limitées par le niveau de bruit. Par exemple, dans le domaine des basses fréquences, des composants tels que des détecteurs photovoltaïques de rayonnement infrarouge possédant des défauts, produisent un niveau de bruit anormalement élevé. La donnée d'un seuil de niveau de bruit acceptable pour une gamme de fréquences donnée définit donc un critère de qualité qui permet de rejeter les composants défectueux.

La détermination d'autres caractéristiques, comme la courbe d'intensité en fonction de la tension appliquée au composant peut compléter la mesure du bruit.

De manière usuelle, les composants à tester sont successivement connectés au dispositif de caractérisation ; un composant connecté est testé, déconnecté puis remplacé par le composant suivant. Le nombre de manipulations pour chaque composant est donc important, ce qui rend pénible la caractérisation d'un grand nombre de composants. C'est dire que dans le cas de plusieurs déterminations de caractéristiques pour chaque composant, les manipulations sont multipliées et la suite d'opérations nécessaires en est d'autant plus fastidieuse.

La présente invention pallie justement ces inconvénients. L'invention résout le problème de la mesure automatique du bruit de composants électronique. Pour résoudre ce problème, le dispositif objet de l'invention sélectionne, les uns après les autres, des composants qui lui sont préalablement connectés et effectue la mesure de bruit (et éventuellement d'autres mesures) sur le composant sélectionné.

On regroupe de cette manière les différentes étapes du processus de caractérisation, ce qui accélère et rend moins pénible les manipulations.

De manière plus précise, la présente invention a pour objet un dispositif de mesure du bruit de composants électroniques, caractérisé en ce qu'il comprend :

  – des moyens de sélection auxquels sont connectés les composants et qui sont aptes à sélectionner l'un de ces composants,

  – des moyens de mesure aptes à déterminer le bruit du composant sélectionné, ces moyens de mesure comprenant des moyens de polarisation du composant sélectionné et de traitement des signaux fournis par le composant sélectionné ainsi polarisé et comprenant également des moyens d'analyse qui déterminent le bruit à partir des signaux fournis par les moyens de traitement, et

  – des moyens de commande des moyens de sélection et des moyens de mesure, ces moyens de commande étant découplés électriquement des moyens de sélection et des moyens de polarisation et de traitement.

Les moyens de mesure peuvent être aptes à déterminer le bruit du composant sélectionné, dans au moins une partie du domaine de fréquences allant de 0,01 Hz à 1 MHz.

Ceci est particulièrement utile pour les composants destinés à recevoir et à fournir des signaux analogiques, notamment dans le domaine de l'imagerie où la gamme des fréquences utilisées se situe dans les basses fréquences, souvent entre 10 Hz et 1 MHz ou bien entre 0,1 Hz et 100 kHz.

La mesure du bruit peut être faite sur la totalité du spectre de fréquences considéré. En effet, lors de la caractérisation de composants, il est intéressant de connaître complétement les composants et dans tout le domaine de fréquences utilisé. Ceci permet de repérer les anomalies éventuelles de mesures, de faire du lissage de courbe et ainsi éventuellement de relier les mesures faites à des modèles théoriques concernant le bruit à basse fréquence, par exemple dans les semiconducteurs.

Des mesures de bruit dans le domaine des basses fréquences posent des problèmes : le bruit des composants est généralement faible (ce qui est souhaitable) et, dans ce domaine, existent toujours des bruits parasites, en particulier le secteur (50 ou 60 Hz), et les harmoniques de celui-ci, le bruit des composants non testés, le bruit d'une source d'alimentation électrique. pour remédier à ces inconvénients, le dispositif objet de l'invention comprend de préférence des moyens autonomes pour l'alimentation électrique des moyens de sélection et des moyens de traitement ; ces moyens d'alimentation autonomes peuvent être en outre prévus pour alimenter les moyens de polarisation. De plus, il est préférable que les composants autres que celui qui a été sélectionné soient mis à la masse. Il est également préférable d'utiliser, dans la partie du dispositif qui est électriquement découplée des moyens de commande, des éléments à faible bruit. On verra par la suite que certains moyens du dispositif nécessitent des commutateurs ; on utilise alors de préférence pour ces derniers des relais à haute isolation électrique qui perturbent de manière négligeable les mesures de bruit. On utilise par exemple des relais du genre de ceux qui sont commercialisés par la société SEEM sous la référence R608.

Selon un mode de réalisation particulier, les moyens de commande sont connectés aux moyens de sélection et aux moyens de polarisation et de traitement par l'intermédiaire de liaisons à optocoupleurs.

On diminue ainsi considérablement les sources de bruits parasites pouvant perturber les mesures, en particulier le secteur.

Le dispositif objet de l'invention peut comprendre en outre :

– d'autres moyens de mesure qui sont aptes à déterminer au moins une caractéristique, autre que le bruit, du composant sélectionné, et qui sont commandés par les moyens de commande, et

– des moyens de configuration qui sont aptes à sélectionner soit lesdits moyens de mesure soit lesdits autres moyens de mesure et qui sont commandés par les moyens de commande et découplés électriquement de ces derniers.

De cette manière, pour chaque composant plusieurs mesures peuvent être réalisées sans pour autant nécessiter des manipulations supplémentaires. Le choix des tests à réaliser est effectué préalablement par l'utilisateur.

De préférence, les moyens de configuration comprennent une pluralité de relais à haute isolation électrique qui sont commandés par les moyens de commande, par l'intermédiaire de liaisons à optocoupleurs, et dont l'ouverture ou la fermeture permet de sélectionner la mesure de bruit ou la mesure d'une caractéristique autre que le bruit.

Selon un mode de réalisation préféré, les moyens de sélection comportent des points de connexion pour la connexion des composants à tester, chaque point de connexion étant relié à un premier et un second relais à haute isolation électrique, montés en inverseur, le premier relais étant aussi connecté à la masse, le second relais étant aussi relié aux moyens de mesure, les relais connectés aux différents points de connexion étant commandés par les moyens de commande.

Selon un autre mode de réalisation préféré, lorsque le dispositif comporte les autres moyens de mesure et les moyens de configuration, les moyens de sélection comportent des points de connexion pour la connexion des composants à tester, chaque point de connexion étant relié à un premier et un second relais à haute isolation électrique, montés en inverseur, le premier relais étant aussi connecté à la masse, le second relais étant aussi relié aux moyens de configuration, les relais connectés aux différents points de connexion étant commandés par les moyens de commande.

Enfin, les moyens d'analyse peuvent comprendre un analyseur de spectre.

D'autres caractéristiques et avantages de l'invention apparaîtront mieux à la lecture de la description suivante d'exemples de réalisation, donnés à titre purement indicatif et nullement limitatif, en référence aux dessins annexés dans lesquels :

– la figure 1 représente schématiquement un dispositif conforme à l'invention,

– la figure 2 représente schématiquement un mode de réalisation particulier de moyens de sélection utilisés dans ce dispositif conforme à l'invention,

– la figure 3 représente schématiquement un mode de réalisation particulier de moyens de configuration utilisés dans ce dispositif conforme à l'invention,

– la figure 4 représente schématiquement un système de polarisation utilisé dans ce dispositif conforme à l'invention.

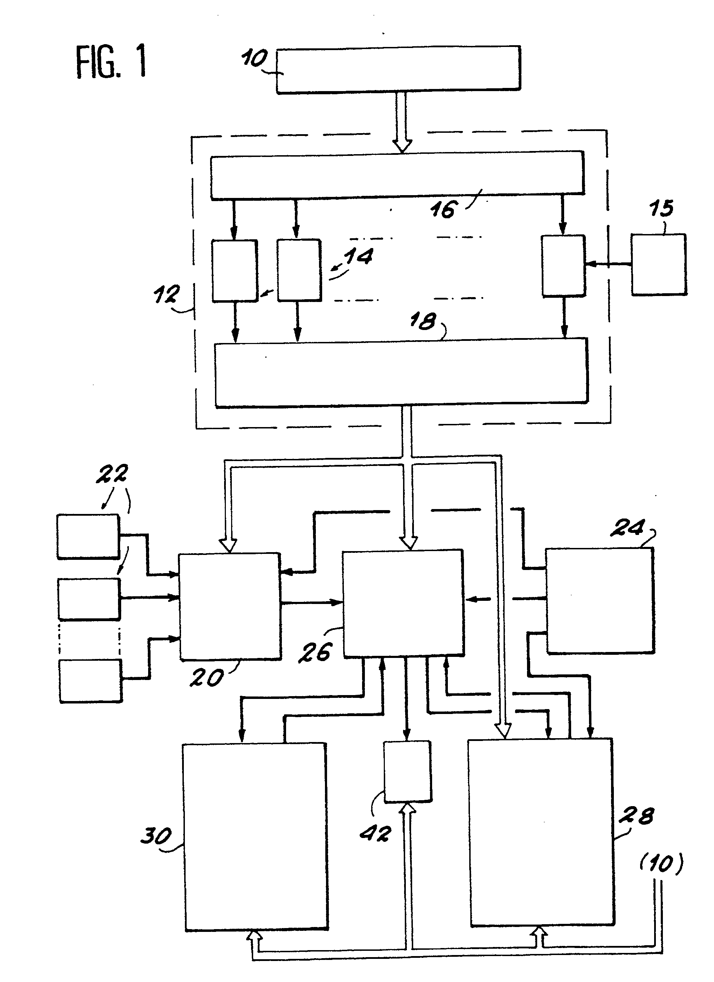

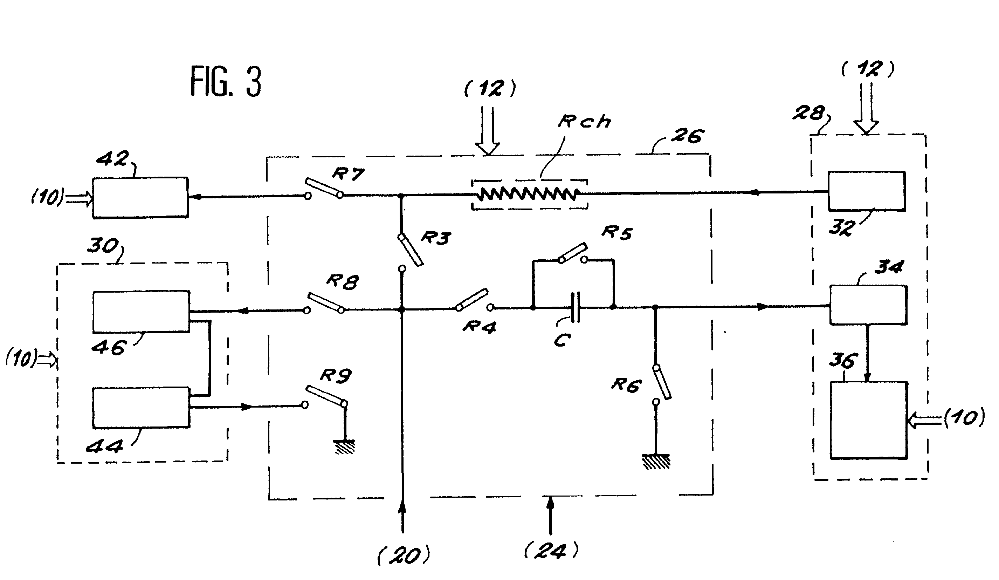

Un dispositif conforme à l'invention est schématiquement représenté sur la figure 1. Ce dispositif comprend une partie dite "externe" et une partie dite "interne" qui est électriquement découplée de la partie externe. On indique dès maintenant les références des éléments qui appartiennent respectivement à ces parties. La nature de ces divers éléments sera indiquée par la suite. Dans la partie interne, on trouve les éléments qui portent les références 12, 24, 26, 32 et 34. Dans la partie externe, on trouve les éléments qui portent les références 10, 15, 30, 36 (voir figure 3) et 42 ainsi que les composants 22 que l'on veut tester. Les éléments qui portent les références 30, 36 et 42 sont pilotés par un calculateur (élément référencé 10) directement via la partie externe.

Dans le dispositif représenté sur la figure 1, le calculateur 10, par exemple du type microordinateur, gère et commande l'ensemble du dispositif. Il appartient à la partie externe du dispositif et il est relié à la partie interne du dispositif par l'intermédiaire d'une interface 12. Cette interface 12 comprend des liaisons à optocoupleurs 14. Un bus 16 (par exemple du type IEEE 488) permet de délivrer aux optocoupleurs 14 les instructions de commande en provenance du calculateur 10. Les optocoupleurs 14 permettent l'isolement électrique du calculateur 10 associé, et par conséquent, une réduction des bruits éventuels pouvant perturber les mesures. Les optocoupleurs 14 transmettent les informations à travers des moyens de sortie 18 qui délivrent les instructions de commande sur par exemple trente deux bits.

Les optocoupleurs 14 peuvent être alimentés en énergie électrique par une alimentation qui porte la référence 15 sur la figure 1 et qui appartient à la partie externe du dispositif. En variante, l'alimentation des optocoupleurs 14 est prélevée sur le calculateur 10.

Le calculateur 10 est connecté par l'intermédiaire de l'interface 12 à des moyens de sélection 20. Les composants électroniques à tester 22 sont préalablement connectés à ces moyens de sélection 20. Ces derniers, commandés par le calculateur 10 par un signal codé sur par exemple huit bits, sélectionnent, les uns après les autres, les composants 22 pour leur caractérisation successive. Par composants, il faut entendre soit des composants différents, soit différents points de mesure d'un composant intégré complexe.

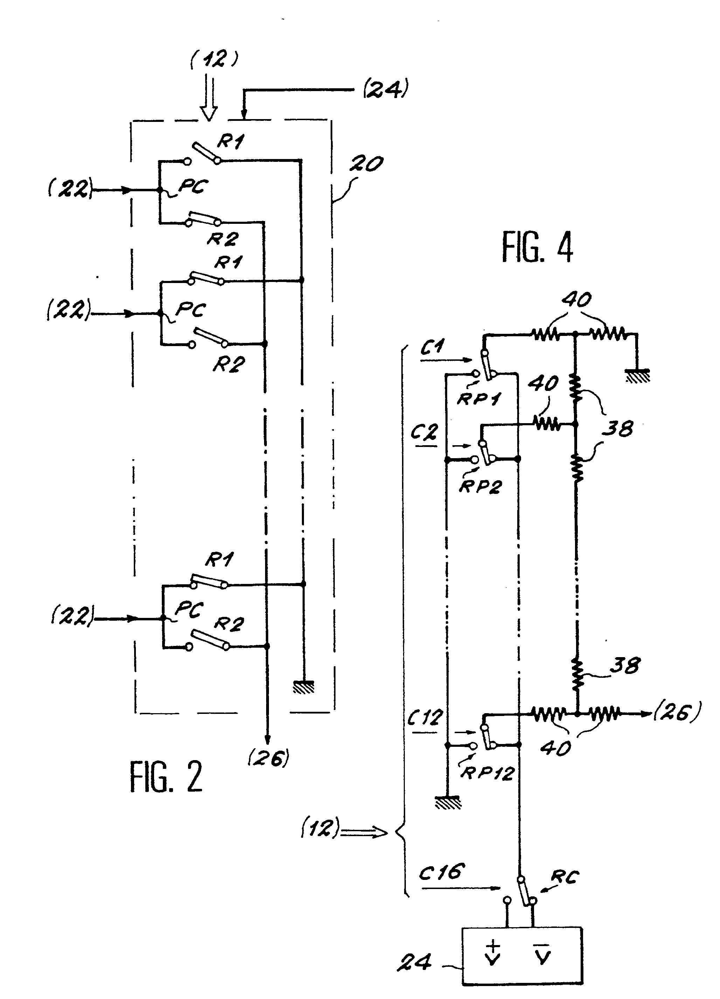

La figure 2 représente schématiquement un mode de réalisation de moyens 20 qui permettent la sélection d'un composant sans apport de bruit parasite. Les composants 22 sont connectés aux moyens de sélection 20 en des points de connexion PC. La sélection d'un composant est assurée par des jeux de relais R1 et R2 montés en inverseur et reliés entre eux en chaque point de connexion PC. Les relais R1, R2 sont choisis à haut isolement électrique et à faible bruit, par exemple du type commercialisé par la Société SEEM sous la référence R 608.

L'ouverture du premier relais R1 et la fermeture du second relais R2 simultanées permettent d'introduire le composant sélectionné dans le circuit de mesure.

Dans l'exemple représenté, un seul composant 22 est sélectionné pour la mesure de bruit et éventuellement d'autres mesures, via le seul relais R2 qui est alors fermé, et les autres composants 22 sont tous reliés à la masse électrique via les relais R1. Ceci est la meilleure façon de procéder pour mesurer le bruit car, de cette manière, les composants non sélectionnés ne perturbent pas la mesure de bruit effectuée sur le composant sélectionné.

Pour chaque composant non sélectionné, la fermeture du premier relais R1 qui a une borne à la masse, et l'ouverture du second relais R2 déconnectent ce composant du circuit de mesure.

En revenant à la figure 1, on voit que les moyens de sélection 20, pour l'alimentation des relais R1, R2, sont connectés à une alimentation générale 24, réalisée avantageusement par des accumulateurs au nickel-cadmium rechargeables, par exemple des accumulateurs selon la référence 10 Ah commercialisés par la Société SAFT. L'utilisation d'accumulateurs permet d'éviter l'introduction de bruits parasites provenant du secteur.

Ainsi, le système de mesure est-il quasiment isolé de son environnement, ce qui n'est pas essentiel pour des mesures de signaux classiques mais qui est essentiel pour des mesures de bruit dans le domaine des basses fréquences en particulier à cause des problèmes de bruit parasites dus au secteur à 50 ou 60 Hz et aux harmoniques de celui-ci.

Des moyens de configuration 26 connectés aux moyens de sélection 20 et alimentés par l'alimentation générale 24 permettent de sélectionner des moyens de mesure 28 ou 30 pour déterminer le bruit ou une autre caractéristique. Dans l'exemple représenté, les moyens de configuration 26 sont connectés aux moyens 28 pour déterminer le niveau de bruit engendré par le composant testé et aux moyens 30 de détermination de la caractéristique courant-tension du composant testé (courbe I(V)).

Les moyens de configuration 26 ainsi que les moyens de mesure 28, 30 associés sont décrits en référence à la figure 3.

Dans l'exemple représenté, où deux moyens de mesure 28 et 30 sont utilisés, la sélection de telle ou telle fonction est effectuée grâce à l'ouverture ou la fermeture de relais R3, ..., R9. Ces relais R3 à R9 sont montés de la manière indiquée sur la figure 3 et sont commandés par le calculateur 10 par l'intermédiaire de l'interface 12. Ces relais peuvent être du type de ceux commercialisés par la Société SEEM sous la référence R 608 ; ils sont alimentés par l'alimentation générale 24.

Pour la sélection des moyens 28 pour déterminer le niveau de bruit engendré par le composant mis en circuit par les moyens de sélection 20, les relais R3 et R4 sont fermés.

Le relais R3 a pour fonction de relier, par l'intermédiaire d'une résistance de charge Rch, le composant à caractériser, à des moyens de polarisation 32 faisant partie des moyens 28 (qui permettent la mesure du bruit sur le composant ainsi polarisé).

Le relais R4 a pour fonction de relier le composant à mesurer à un préamplificateur 34 faisant partie les moyens 28. On précise que les moyens 28 pour la détermination du niveau de bruit sont composés, de manière classique, des moyens de polarisation 32 pour la polarisation du composant sélectionné, et du préamplificateur 34 par exemple du type PAR 184, commercialisé par la Société EGG Instruments, les moyens 32 et le préamplificateur 34 étant alimentés par l'alimentation générale 24.

Les moyens de mesure 28 comprennent aussi un analyseur de spectre 36 dont l'entrée est reliée à la sortie du préamplificateur 34 et qui est par exemple du genre de celui qui est commercialisé par la société Hewlett-Packard sous la référence HP 3561, cet analyseur 36 appartenant à la partie externe du dispositif (l'analyseur 36 est alimenté par le secteur et piloté directement par le calculateur 10), ce qui ne limite pas les mesures de bruit.

La polarisation est choisie par le calculateur par l'intermédiaire de l'interface 12. Le choix de la polarisation est par exemple effectué par l'intermédiaire d'un signal codé sur 16 bits. Comme on peut le voir sur la figure 4 qui montre le schéma électrique d'un système de polarisation utilisable avec le dispositif de la figure 1, douze de ces bits permettent les commandes C1, ..., C12 de douze relais RP1, ..., RP12, par exemple du type R 625 commercialisé par la Société SEEM.

Chacun de ces relais peut être raccordé soit à la masse, soit à un étage d'un système diviseur de tension, chaque étage étant formé de deux résistances 38, 40. Par exemple, les résistances référencées 38 valent 100 kohms ; les résistances 40 sont de valeur double. Ce type de système diviseur de tension est bien connu et ne nécessite pas de description détaillée.

La polarisation peut être positive, négative ou nulle. La polarisation nulle est obtenue en basculant tous les relais RP1, ..., RP12 à la masse. Les polarisations positive (+V) et négative (-V) sont choisies par l'intermédiaire de la commande C16 d'un relais RC relié à l'alimentation générale 24, comme on le voit sur la figure 4. La valeur de la polarisation est obtenue par la commande du nombre de relais RP1, ..., RP12 adéquat : par exemple, celle-ci peut aller, en valeur absolue, de 0V à 30 V pour une alimentation 24 de 30 V.

Pour une utilisation systématique du dispositif avec une polarisation nulle, les moyens de polarisation 32 peuvent être constitués par une simple connexion à la masse.

En revenant à la figure 3, on voit que le relais R3 est relié aux moyens de polarisation 32 des moyens 28. Un condensateur de liaison C permet l'isolement du préamplificateur 34. Le relais R5 est monté entre les bornes du condensateur C : lors d'une mesure à polarisation nulle, le condensateur C n'est pas nécessaire et est alors shunté par la fermeture du relais R5, d'où un gain de temps et une procédure optimale.

Par ailleurs, lors de la charge du condensateur de liaison C, l'entrée du préamplificateur 34 est mise à la masse par la fermeture du relais R6 ; ceci permet d'éviter la saturation du préamplificateur 34. Le relais R6 est réouvert avant la mesure.

D'autre part, la fermeture du relais R7 permet la mise en circuit d'un voltmètre 42 permettant le contrôle de la valeur de la polarisation. Ce voltmètre 42 appartient à la partie externe du dispositif représenté sur la figure 1.

Pour la détermination de la caractéristique courant-tension, les moyens de configuration 26 possèdent les deux relais R8 et R9 dont la fermeture permet la mise en circuit d'une alimentation électrique variable 44 et d'un picoampèremètre 46 qui forment les moyens 30.

L'alimentation 44 et le picoampèremètre 46 sont avantageusement dans la partie externe du dispositif représenté sur la figure 1 (ils sont alimentés par le secteur et pilotés par le calculateur 10), ce qui ne limite pas la précision de la mesure de la caractéristique courant-tension.

Ceci serait également vrai s'ils étaient dans la partie interne du dispositif mais alors la mesure de bruit pourrait être perturbée. De même, le voltmètre 42 et l'analyseur de spectre 36 pourraient être dans la partie interne du dispositif mais la mesure de bruit pourrait être alors perturbée.

Pour chaque composant sélectionné, la caractéristique courant-tension est obtenue classiquement en faisant varier la tension fournie par l'alimentation électrique 44 et en mesurant le courant au moyen du picoampèremètre 46 (les relais R3 et R4 étant ouverts).

Un dispositif conforme à l'invention permet donc bien d'effectuer automatiquement des séries de mesures permettant de détecter des défauts de structure ou de fabrication de composants électroniques.

Dans la réalisation décrite, les mesures de niveau de bruit sont très sensibles, le bruit propre du dispositif étant très bas.

Il va de soit que l'invention ne se limite nullement à l'exemple de réalisation plus spécialement décrit et représenté. En particulier, d'autres moyens de mesure pourraient-être raccordés aux moyens de configuration pour la détermination de caractéristiques supplémentaires.

## Revendications

1. Dispositif de mesure du bruit de composants électroniques (22), caractérisé en ce qu'il comprend :
   – des moyens de sélection (20) auxquels sont connectés les composants et qui sont aptes à sélectionner l'un de ces composants,
   – des moyens de mesure (28) aptes à déterminer le bruit du composant sélectionné, ces moyens de mesure comprenant des moyens (32, 34) de polarisation du composant sélectionné et de traitement des signaux fournis par le composant sélectionné ainsi polarisé et comprenant également des moyens (36) d'analyse qui déterminent le bruit à partir des signaux fournis par les moyens de traitement, et
   – des moyens (10) de commande des moyens (20) de sélection et des moyens (28) de mesure, ces moyens de commande (10) étant découplés électriquement des moyens de sélection (20) et des moyens de polarisation et de traitement (32, 34).

2. Dispositif selon la revendication 1, caractérisé en ce que les moyens de mesure (28) sont aptes à déterminer le bruit du composant sélectionné, dans au moins une partie du domaine de fréquences allant de 0,01 Hz à 1 MHz.

3. Dispositif selon la revendication 2, caractérisé en ce qu'il comprend en outre des moyens autonomes (24) pour l'alimentation électrique des moyens de sélection (20) et des moyens de traitement (34).

4. Dispositif selon la revendication 3, caractérisé en ce que les moyens autonomes sont en outre prévus pour alimenter les moyens de polarisation (32).

5. Dispositif selon l'une quelconque des revendications 1 à 4, caractérisé en ce que les composants autres que celui qui a été sélectionné sont mis à la masse.

6. Dispositif selon l'une quelconque des revendications 1 à 5, caractérisé en ce que les moyens de commande (10) sont connectés aux moyens de sélection (20) et aux moyens de polarisation et de traitement (32, 34) par l'intermédiaire de liaisons à optocoupleurs (14).

7. Dispositif selon l'une quelconque des revendications 1 à 6, caractérisé en ce qu'il comprend en outre :
   – d'autres moyens de mesure (30) qui sont aptes à déterminer au moins une caractéristique, autre que le bruit, du composant sélectionné, et qui sont commandés par les moyens de commande (10), et
   – des moyens de configuration (26) qui sont aptes à sélectionner soit lesdits moyens de mesure (28) soit lesdits autres moyens de mesure (30) et qui sont commandés par les moyens de commande (10) et découplés électriquement de ces derniers.

8. Dispositif selon la revendication 7, caractérisé en ce que les moyens de configuration (26) comprennent une pluralité de relais à haute isolation électrique (R3 à R9) qui sont commandés par les moyens de commande (10), par l'intermédiaire de liaisons à optocoupleurs (14), et dont l'ouverture ou la fermeture permet de sélectionner la mesure de bruit ou la mesure d'une caractéristique autre que le bruit.

9. Dispositif selon l'une quelconque des revendications 1 à 8, caractérisé en ce que les moyens de sélection (20) comportent des points de connexion (PC) pour la connexion des composants (22) à tester, chaque point de connexion (PC) étant relié à un premier et un second relais (R1, R2) à haute isolation électrique, montés en inverseur, le premier relais (R1) étant aussi connecté à la masse, le second relais (R2) étant aussi relié aux moyens de mesure (28), les relais (R1, R2) connectés aux différents points de connexion (PC) étant commandés par les moyens de commande (10).

10. Dispositif selon l'une quelconque des revendications 7 et 8, caractérisé en ce que les moyens de sélection (20) comportent des points de connexion (PC) pour la connexion des composants (22) à tester, chaque point de connexion (PC) étant relié à un premier et un second relais (R1, R2) à haute isolation électrique, montés en inverseur, le premier relais (R1) étant aussi connecté à la masse, le second relais (R2) étant aussi relié aux moyens de configuration (26), les relais (R1, R2) connectés aux différents points de connexion (PC) étant commandés par les moyens de commande (10).

11. Dispositif selon l'une quelconque des revendications 1 à 10, caractérisé en ce que les moyens d'analyse comprennent un analyseur de spectre (36).

FIG. 1

FIG. 3

FIG. 2

FIG. 4

Office européen
des brevets

**RAPPORT DE RECHERCHE EUROPEENNE**

Numero de la demande

EP  91 40 1258

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | IEEE TRANSACTIONS ON NUCLEAR SCIENCE, vol. NS-31, no. 1, février 1984, pages 465-469; C.E. COX et al.: "High precision measurement of transistor noise with automatic calibration under computer control" <br> * Page 466, figure 3; page 467, figure 5 et colonne de gauche; page 468, alinéa 3 * <br> --- | 1,2,7,8 , | G 01 R· 31/26 |
| Y | RADIO FERNSEHEN ELEKTRONIK, vol. 29, no. 6, 1980, pages 387-389; R. PALM et al.: "Tester für analoge Bauelemente" <br> * Page 387, Bild 1 * <br> --- | 1,2,7,8 | |
| A | FR-A-2 381 316  (HUNTRON) <br> --- | | |
| A | MICROWAVE JOURNAL, vol. 31, no. 9, septembre 1988, pages 275-278; "An on-wafer noise parameter and S-parameter measurement system" <br> ----- | | |

**DOMAINES TECHNIQUES RECHERCHES (Int. Cl.5)**

G 01 R

Le présent rapport a été établi pour toutes les revendications

| Lieu de la recherche | Date d'achèvement de la recherche | Examinateur |
|---|---|---|
| LA HAYE | 26-06-1991 | HOORNAERT W. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&  : membre de la même famille, document correspondant

EPO FORM 1503 03.82 (P0402)